(19) Europäisches Patentamt
European Patent Office
Office européen des brevets

(11) EP 2 282 345 B1

(12) EUROPEAN PATENT SPECIFICATION

(45) Date of publication and mention
of the grant of the patent:
**09.04.2014  Bulletin 2014/15**

(51) Int Cl.:
***H01L 27/146*** (2006.01)

(21) Application number: **10251166.4**

(22) Date of filing: **28.06.2010**

(54) **Imaging sensor with transfer gate having multiple channel sub-regions**

Bildsensor mit einem Übertragungsgate mit mehreren Kanalunterregionen

Capteur d'imagerie doté d'une grille de transfert avec plusieurs sous-régions de canal

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **07.08.2009  US 232369 P
22.02.2010  US 710267**

(43) Date of publication of application:
**09.02.2011  Bulletin 2011/06**

(73) Proprietor: **OmniVision Technologies, Inc.
Santa Clara, CA 95054 (US)**

(72) Inventors:
• **Nozaki. Hidetoshi
Sunnyvale, CA 94087 (US)**
• **Dai, Tiejun
Santa Clara, CA 95051 (US)**

(74) Representative: **Hackney, Nigel John et al
Mewburn Ellis LLP
33 Gutter Lane
London
EC2V 8AS (GB)**

(56) References cited:
**US-A1- 2006 071 254    US-A1- 2006 138 492
US-A1- 2008 179 639    US-A1- 2008 296 630**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

This disclosure relates generally to image sensors, and in particular but not exclusively, relates to CMOS image sensors.

BACKGROUND INFORMATION

Image sensors are widely used in digital still cameras, cellular phones, security cameras, as well as in, medical, automobile, and other applications. Complementary metal-oxide-semiconductor ("CMOS") technology is used to manufacture lower cost image sensors on silicon substrates. In a large number of image sensors, the image sensor commonly includes several light sensor cells or pixels. A typical individual pixel includes a microlens, a filter, a photosensitive element, a floating diffusion region, and one or more transistors for reading out a signal from the photosensitive element. One of the transistors included in the pixel is commonly referred to as a transfer transistor, which includes a transfer gate disposed between the photosensitive element and the floating diffusion. The transfer gate is disposed on a gate oxide. The photosensitive element, floating diffusion region, and gate oxide are disposed on a substrate.

During operation, a conducting channel region may be formed under the transfer gate when a bias voltage is applied to the transfer gate such that signal is transferred from the photosensitive element to the floating diffusion region. However, conventional transfer gates often suffer from image lag and blooming.

Image lag may result from the conventional conducting channel region being unable to remove all the signal from the photosensitive element such that a residual signal remains during successive readings of the pixel. This leftover information remaining in the photosensitive element is often referred to as image lag, residual image, ghosting or frame to frame retention.

Blooming may result from the photosensitive element converting high intensity portions of an image which may cause excess charge to spill into adjacent photosensitive elements. This excess charge may also spill through the conventional transfer gate into the floating diffusion before the intended transfer period. Blooming may limit the imaging sensor's dynamic range and may limit the types of commercial applications of the imaging sensor.

US 2006/0071254 A1 discloses a pixel cell with controlled leakage which is formed by modifying the location and gate profile of a high dynamic range (HDR) transistor. The HDR transistor may have a dual purpose, acting as both a leaking transistor and either a transfer gate or a reset gate. Alternatively, the HDR transistor may be a separate and individual transistor having the gate profile of a transfer gate or a reset gate. The leakage through the HDR transistor may be controlled by modifying the photodiode implants around the transistor, adjusting the channel length of the transistor, or thinning the gate oxide on the transistor. The leakage through the HDR transistor may also be controlled by applying a voltage across the transistor.

The invention provides an image sensor pixel as set out in claim 1 and an image sensor as set out in claim 9.

BRIEF DESCRIPTION OF THE DRAWINGS

Exemplary embodiments are described with reference to the following figures, wherein like reference numerals refer to like parts throughout the various views unless otherwise specified.

FIG. 1 is a cross-sectional view of an image sensor pixel including a conventional transfer gate channel doping structure.
FIG. 2 is a cross-sectional view of an image sensor pixel including a transfer gate channel doping, in accordance with an embodiment.
FIGS. 3A-3D are cross sectional views of a process for forming a transfer gate and pixel, in accordance with an embodiment.
FIG.4 is a block diagram illustrating an image sensor, in accordance with an embodiment.
FIG. 5 is a circuit diagram illustrating sample pixel circuitry of two image sensor pixels within an image sensor array, in accordance with an embodiment.
FIG. 6 is a block diagram illustrating an imaging system, in accordance with an embodiment.

DETAILED DESCRIPTION

Embodiments of a pixel, an image sensor, an imaging system, and methods of fabrication of a pixel, image sensor, and imaging system having improved image lag and blooming characteristics are described herein. In the following description numerous specific details are set forth to provide a thorough understanding of the embodiments. One skilled in the relevant art will recognize, however, that the techniques described herein can be practiced without one or more of the specific details, or with other methods, components, materials, etc. In other instances, well-known structures, materials, or operations are not shown or described in detail to avoid obscuring certain aspects. For example, although not illustrated, it should be appreciated that image sensor pixels may include a number of conventional layers (e.g., antireflective films, etc.) used for fabricating CIS pixels. Furthermore, the illustrated cross sections of image sensor pixels illustrated herein do not necessarily illustrate the pixel circuitry associated with each pixel. However, it should be appreciated that each pixel may include pixel circuitry coupled to its collection region for performing a variety of functions, such as commencing image acquisition, resetting accumulated image charge, transferring out acquired image data, or otherwise.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

A typical CMOS image sensor (CIS) pixel operates as follows. Light is incident on the micro-lens, which focuses the light to the photosensitive element through the filter. The photosensitive element detects the light and converts the light into an electrical signal proportional to the intensity of the light detected. The transfer gate transfers the electrical signal from the photosensitive element to the floating diffusion region.

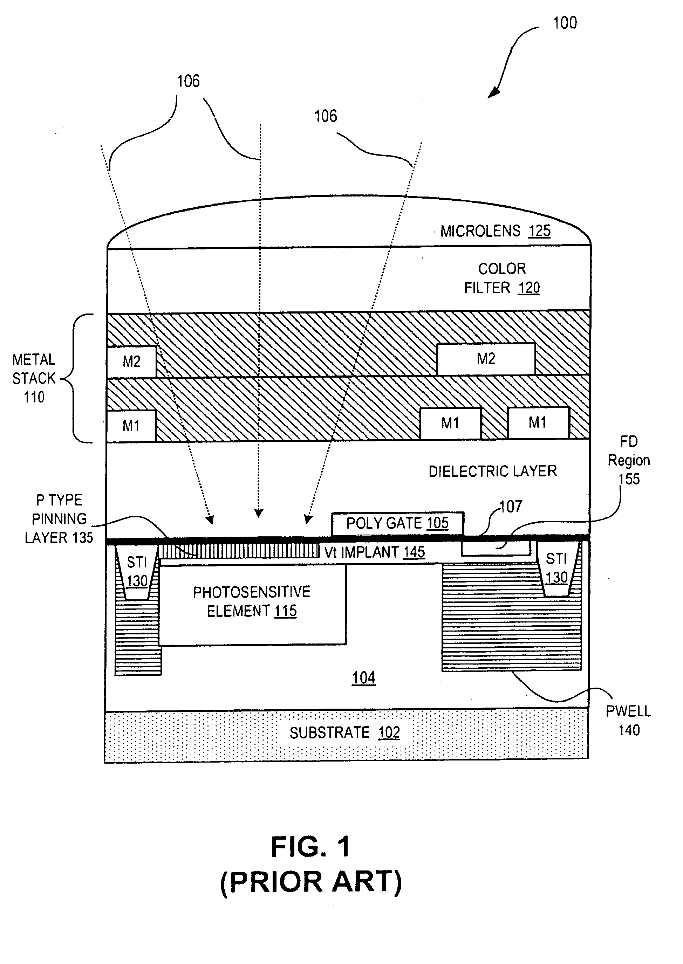

FIG. 1 illustrates a cross-sectional view of a conventional image sensor pixel 100 of a frontside illuminated CIS including a conventional transfer gate channel doping structure. A metal stack 110 includes metal layers (e.g., metal layer M1 and M2), which are patterned in such a manner as to create an optical passage through which light 106 incident on pixel 100 can reach photosensitive or photodiode ("PD") element 115. To implement a color CIS, pixel 100 further includes a color filter layer 120 disposed under a microlens 125. Microlens 125 aids in focusing light 106 onto photosensitive element 115. Generally, an image sensor includes several image sensor pixels 100 arranged in an array of two dimensional rows and columns in a larger substrate (i.e., extending beyond substrate 102 as shown). Pixel 100 further includes a floating diffusion (FD) region 155 disposed in a P type doped well 140 on epitaxial layer 104. As shown in FIG. 1, epitaxial layer 104 is disposed on substrate 102. Shallow trench isolation (STI) 130 also is disposed in or on epitaxial layer 104. A transfer transistor having a transfer poly gate 105 is disposed between photosensitive element 115 and FD region 155, and is used to transfer the signal output from photosensitive element 115 to floating diffusion region 155. A conducting channel (i.e., through a Vt implant region 145) may be formed under the transfer gate when a bias voltage is applied to it. The bias voltage at which the channel forms may be called the Threshold Voltage (Vt).

Pixel 100 operates as follows. During an integration period (also referred to as an exposure or accumulation period), light 106 is incident on photosensitive element 115. Photosensitive element 115 generates an electrical signal in response to the incident light. The electric signal is held in photosensitive element 115. At this stage, the transfer transistor may be turned off. In one embodiment, the bias voltage on poly gate 105 may be a negative voltage.

When the bias voltage on poly gate 105 is less than its threshold voltage, Vt implant region 145 effectively becomes resistant to electron flow. A driving force is created that tends to hinder electron motion from photosensitive element 115 to floating diffusion region 155.

After the integration period, transfer gate 105 is turned on to read out photosensitive element 115. In one embodiment, a positive bias voltage may be applied to poly gate 105. When the bias on poly gate 105 is increased, Vt implant region 145 near FD region 155 becomes conductive first. The channel may continue to gradually become conductive toward photosensitive element 115 as the threshold voltage is approached. The potential in Vt implant region 145 is dependent on the doping concentration at each point within Vt implant region 145. In the conventional transfer gate channel doping structure, the potential gradually decreases from photosensitive element 115 toward FD region 155, thereby generating a lateral electric field that aids the transfer of charge from the photosensitive element the floating diffusion. After the electrical signal in photosensitive element 115 has been transferred to FD region 155, poly gate 105 is turned off for the start of a subsequent integration period.

The conventional transfer gate however suffers from image lag and blooming. This problem arises because conventional channel doping structures are doped such that a potential barrier remains under the transfer poly gate near the photosensitive element and a residual signal charge is prevented from being transferred. In addition, during the integration period such conventional channel doping structures are incapable of completely removing charges in excess of full well capacity and preventing blooming.

Further, photosensitive element 115 may not be completely emptied between successive readings. Some of the information from the previous light signal remains in the photosensitive element, having not been transferred to the floating diffusion. The leftover information may be termed image lag, residual image, ghosting, frame to frame retention, etc.

Additionally, photosensitive element 115 may not be able to accommodate all the charge converted from high intensity portions of an image and it may spill that excess charge into adjacent photosensitive elements. The excess charge may also spill through the transfer gate into the floating diffusion before the intended transfer period. This effect is called blooming and it limits imager dynamic range and as a result may limit the types of commercial applications of image sensor pixel 100.

One method of dealing with image lag and blooming is to use as a starting point a uniform dopant underneath the transfer gate. This is typical for transfer transistors using zero applied volts on their gate during collection of the electrical signal. These typical transfer transistors are fabricated in part by ion implanting a P type dopant uniformly throughout the gate region in order to set a near zero threshold voltage. In addition to the uniform threshold implant, a more heavily doped P type layer can be implanted where the transfer gate overlaps the photodiode, in accordance with embodiments of the present invention. This combination creates a stepwise graded P type doping region under the transfer gate and within the channel region. A lateral electric field is created by means of the graded P type doping of the channel between the photosensitive element and the floating diffusion region, which accelerates the electrons in the channel during readout. In addition, during the photo accumulation period, when the transfer transistor is held below its threshold at zero volts or a small negative voltage, the lateral electric field may direct and remove excess charge from the photodiode, if it should saturate, and thereby reduce blooming. Yet another action of the lateral electric field is to direct dark current generated under the transfer gate away from the photodiode and prevents it from being added to the accumulated photodiode charge.

However, this approach can cause three potential problems. One potential problem is a reduction in full well capacity due to the diffusion of the additional P type dopant into the photosensitive element. If the additional P type dopant is diffused into the photosensitive element, the N type dopants in the photosensitive element may be compensated and the amount of charge the individual photosensitive element can hold before saturating may be reduced. A second potential problem is the formation of a potential energy barrier at the region where the photosensitive element connects to the channel underneath the transfer gate. Consequently, not all the photo-generated electrons are able to leave the photosensitive element during readout as some are not energetic enough to cross this potential energy barrier.

A third potential problem is that although the zero volt threshold of the transfer gate tends to help direct charge out of the photodiode during moderate blooming, the associated typical channel P type doping level is too high and more severe blooming is not accommodated. The excess signal charge can overflow into adjacent photodiodes. There is need of an improved transfer gate doping scheme that maximizes photosensitive element full well capacity while preventing blooming and image lag.

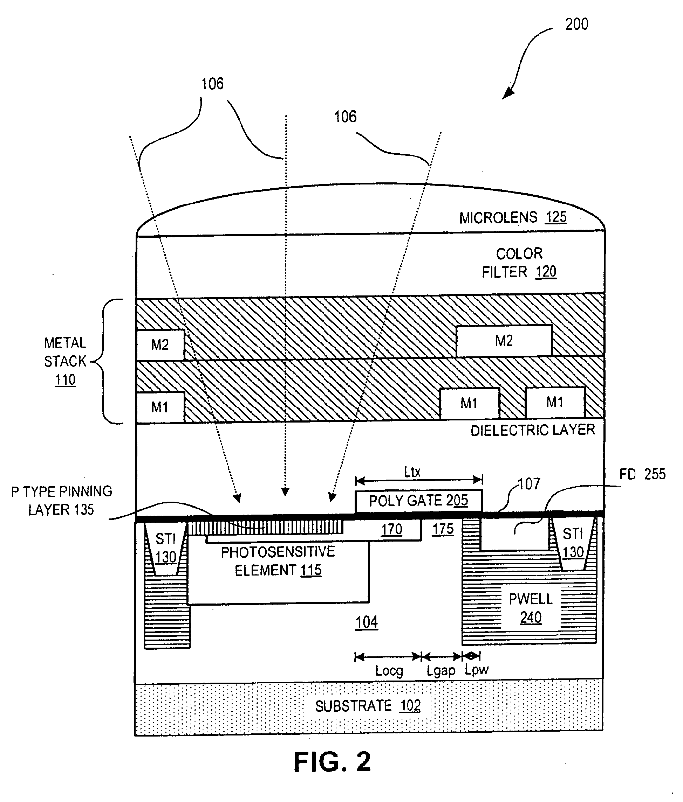

FIG. 2 illustrates a cross-sectional view of an image sensor pixel 200 of a CIS including a transfer gate channel doping structure according to an embodiment of the present invention. According to an embodiment, the CIS includes an array of pixels 200 disposed in a substrate. An individual image sensor pixel includes a photosensitive element 115 and a floating diffusion region 255. A transfer gate 205 with a gate oxide 107 having a uniform thickness is disposed between the photosensitive element 115 and the floating diffusion region 255. The floating diffusion 255 is contained within a P type well 240 that extends underneath the transfer gate 205. Included in the image sensor pixel 200 is a transistor channel region that includes at least two different sub-regions each having different doping concentrations. The first sub-region is a P type doped region called an Overflow Charge Guide (OCG) 170 and is positioned under the transfer gate 205 between it and the photosensitive element 115. In other embodiments the OCG may extend over some or the entire photosensitive element 115. The second sub-region is a region between the OCG and the floating diffusion P Well that can be called a gap 175 and it is either doped very low P-type, left undoped, or doped slightly N type. Channel sub regions 170 and 175 may be collectively referred to herein as a transfer transistor channel region.

As can be seen in FIG. 2, the conventional threshold implant Vt is absent from the gap 175. For ease of fabrication it may simply retain the doping concentration of the starting P-type epitaxial layer 104. The gap region 175 provides for a larger capacity to drain away excess signal charge while the transfer gate 205 is held off for signal integration. Because the gap doping is significantly lower than conventional designs it allows the optimization of the choices of doping concentrations in the OCG region 170 and photosensitive element 115 so that blooming and image lag are significantly reduced while photosensitive element 115 full well capacity is maximized.

An embodiment of the image sensor pixel 200 operates in a somewhat similar manner to sensor cell 100. However, since gap region 175 is doped much lower than OCG region 170, and also since the two regions can be doped more optimally with respect to photosensitive element 115 than would be the conventional channel structure, sensor cell 200 reduces image lag and blooming. For example, OCG region 170 can be doped at an intermediate level between heavy P+ doping of pinning layer 135 and lighter P-type doping that would be normally in the channel region. Such an embodiment of sensor cell 200 may effectively be applied to more demanding imaging applications such as in the medical, security, and automotive industries.

Certain length dimensions of image sensor 200 are defined herein, although it is appreciated that the FIG. 2 provided herewith is for explanation purposes to persons ordinarily skilled in the art and that the drawing is not necessarily drawn to scale. Ltx refers to the width of poly gate 205. Locg refers to the width of a portion of the OCG region 170 from the edge of poly gate 205 to the far extent of OCG region 170 under poly gate 205. Lgap refers to the width of gap region 175, which extends from the edge of P Well 240 to the edge of OCG region 170. Lpw refers to the width of a portion of P Well 240 that extends from the edge of floating diffusion 255 to the far extent of P Well 240 under poly gate 205. The ranges for Locg, Lgap and Lpw may be as follows:

$$\text{Lgap} > 0.05 \ \mu\text{m} \quad (\text{e.g., Lgap} > 0.2 \ \mu\text{m})$$

$$Locg < 1/2\ Ltx \quad (e.g.,\ Locg < 1/3\ Ltx)$$

$$Lpw < 1/2\ Ltx \quad (e.g.,\ Lpw < 1/3\ Ltx)$$

The ranges for the boron concentrations of P type doped epitaxial layer 104 and P type doped OCG 170 may be as follows:

P type doped epitaxial layer 104: from $1 \times 10^{14}$ cm$^{-3}$ to $1 \times 10^{16}$ cm$^{-3}$ (e.g., $2 \times 10^{14}$ cm$^{-3}$ to $3 \times 10^{15}$ cm$^{-3}$) P type OCG (peak concentration) 170: from $1 \times 10^{16}$ cm$^{-3}$ to $1 \times 10^{18}$ cm$^{-3}$ (e.g., $3 \times 10^{16}$ cm$^{-3}$ to $5 \times 10^{17}$ cm$^{-3}$)

For certain embodiments, epitaxial layer 104 may be any suitable semiconductor material, such as silicon. In the illustrated embodiment, epitaxial layer 104 is P type doped silicon. However, in another embodiment, epitaxial layer 104 can be (slightly) N type doped silicon.

The gate oxide 107 may be any suitable insulating material, such as silicon dioxide. Poly gate 205 may be polysilicon or any suitable gate material. STI 130 may be any suitable insulating material capable of preventing leakage of electrical signals between components on the substrate 102.

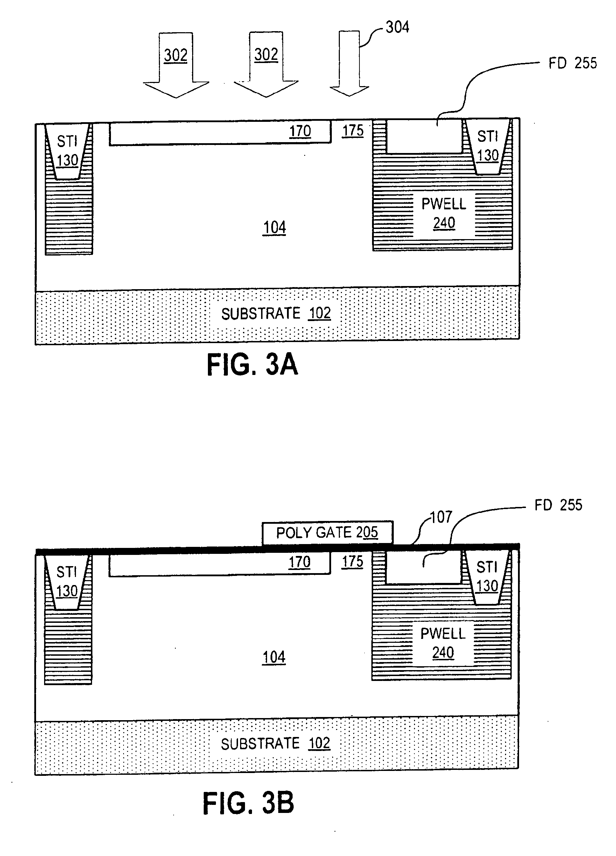

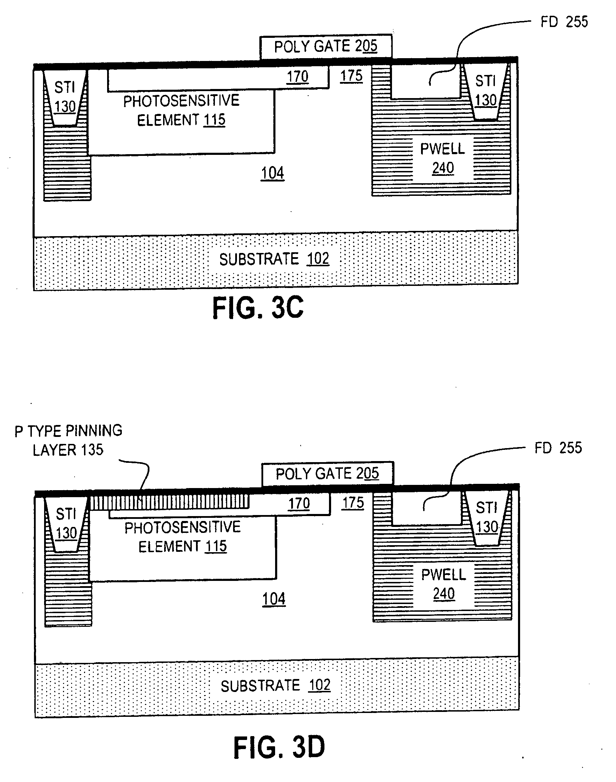

FIGs. 3A - 3D illustrate one technique for fabricating image sensor pixel 200, in accordance with one embodiment. FIG. 3A illustrates a cross section of a pixel similar to pixel 200 which has been fabricated to the point where STIs 130, doped well 240, and floating diffusion 255 have been formed within epitaxial layer 104 which is disposed on substrate 102.

Embodiments described herein may be formed using industry standard fabrication techniques used to fabricate CMOS image sensors. Photolithography, ion implantation, chemical vapor deposition (CVD), and etching are among standard industry practices used to fabricate CMOS image sensors. One method will form the OCG region 170 by ion implantation of a P type dopant 302 within a designated portion of an image sensor element, as shown in FIG. 3A.

As stated above, in one embodiment, epitaxial layer 104 is P type doped silicon. In this embodiment the image sensor element as described above may, in addition, place an optional N type dopant 304 in the gap region 175 by ion implantation prior to forming the poly gate 105. In another embodiment, epitaxial layer 104 is (slightly) N type doped silicon. As such, optional implant 304 may be a P type dopant implanted in the N type doped silicon embodiment of epitaxial layer 104.

In the embodiment where optional dopant 304 is a N type dopant implanted into a P type doped silicon, the gap region 175 will become more lightly P type or slightly N type relative to the OCG region 170 creating the lateral electric field that minimizes image lag during photo-signal transfer, as well as blooming and dark current during photo-signal accumulation.

Referring next to FIG. 3B, transfer transistor poly gate 205 is formed using CVD, Photolithography, and etching such that the OCG 170 lies at least a distance Locg under the poly gate at the side adjacent to the photosensitive element. The Photosensitive element 115 may then be formed by ion implantation of an N type dopant within a designated portion of the image sensor under the OCG region and substantially aligned to the transfer poly gate edge as shown in FIG. 3C. A P type pinning layer 135 may then be formed at the epitaxial layer 104 surface above the OCG region 170 and above the N type photosensitive element 115 by ion implantation.

In the disclosed embodiment, substrate 102 may be P type doped, epi layer 104 may be P type doped, doped wells 240 may be may be P type doped, floating diffusion 255 may be N type doped, photosensitive element 115 may be N type doped, pinning layer 135 may be P type doped, OCG 170 may be P type, and transfer gate 205 may be N type doped. It should be appreciated that the conductivity types of all the elements can be swapped such that, for example, substrate 102 may be N+ doped, epi layer 104 may be N- doped, well regions 130 may be N doped, OCG 170 may be N type doped, and photosensitive element 115 may be P doped.

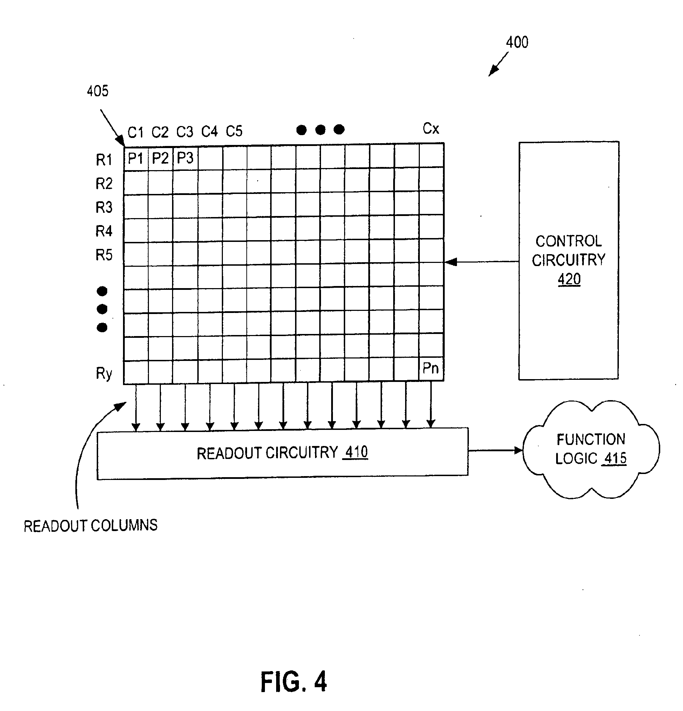

FIG. 4 is a block diagram illustrating a CIS 400, in accordance with an embodiment. The illustrated embodiment of CIS 400 includes pixel array 405 having some or all of the above described improved characteristics, readout circuitry 410, function logic 415, and control circuitry 420. Pixel array 405 is a two-dimensional ("2D") array of image sensor pixels (e.g., pixels P1, P2 ..., Pn). In one embodiment, each pixel is implemented using pixel 200, illustrated in FIG 2. In one embodiment, each pixel is a CIS pixel. In one embodiment, pixel array 405 includes a color filter array including a color pattern (e.g., Bayer pattern or mosaic) of red, green, and blue filters. As illustrated, each pixel is arranged into a row (e.g., rows R1 to Ry) and a column (e.g., column C1 to Cx) to acquire image data of a person, place, or object, which can then be used to render a 2D image of the person, place, or object.

After each pixel has acquired its image data or image charge, the image data is readout by readout circuitry 410 and transferred to function logic 415. Readout circuitry 410 may include amplification circuitry, analog-to-digital ("ADC") conversion circuitry, or otherwise. Function logic 415 may simply store the image data or even manipulate the image data by applying post image effects (e.g., crop, rotate, remove red eye, adjust brightness, adjust contrast, or otherwise). In one embodiment, readout circuitry 410 may readout a row of image data at a time along readout column lines (illustrated) or may readout the image data using a variety of other techniques (not illustrated), such as a column/row readout, a serial readout, or a full parallel readout of all pixels simultaneously. Control circuitry 420 is connected with pixel array 405 to control operational characteristic of pixel array 405. For example, control circuitry 420 may generate a shutter signal for controlling image acquisition.

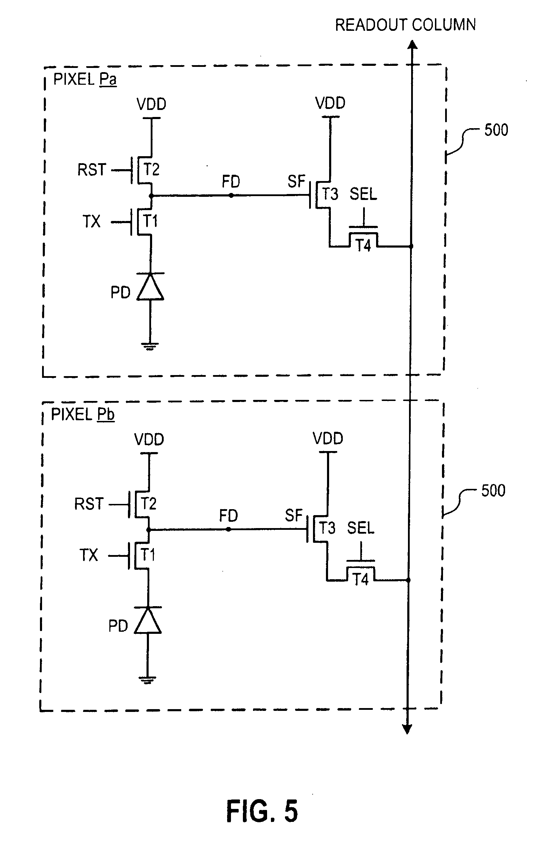

FIG. 5 is a circuit diagram illustrating a pixel circuitry 500 of two four-transistor ("4T") pixels within a pixel array, in accordance with an embodiment of the invention. Pixel circuitry 500 is one possible pixel circuitry architecture for implementing each pixel within pixel array 405 of FIG. 4. However, it should be appreciated that embodiments of the present invention are not limited to 4T pixel architectures; rather, one of ordinary skill in the art having the benefit of the instant disclosure will understand that the present teachings are also applicable to 3T designs, 5T designs, and various other pixel architectures.

In FIG. 5, pixels Pa and Pb are arranged in two rows and one column. The illustrated embodiment of each pixel circuitry 500 includes a photodiode PD, a transfer transistor T1, a reset transistor T2, a source-follower ("SF") transistor T3, and a select transistor T4. In one embodiment, pixels Pa and Pb are implemented using pixel 200, illustrated in FIG 2, wherein transfer transistor T1 includes transfer transistor gate 105. During operation, transfer transistor T1 receives a transfer signal TX, which transfers the charge accumulated in photodiode PD to a floating diffusion node FD. In one embodiment, floating diffusion node FD may be coupled to a storage capacitor for temporarily storing image charges.

Reset transistor T2 is coupled between a power rail VDD and the floating diffusion node FD to reset the pixel (e.g., discharge or charge the FD and the PD to a preset voltage) under control of a reset signal RST. The floating diffusion node FD is coupled to control the gate of SF transistor T3. SF transistor T3 is coupled between the power rail VDD and select transistor T4. SF transistor T3 operates as a source-follower providing a high impedance connection to the floating diffusion FD. Finally, select transistor T4 selectively couples the output of pixel circuitry 500 to the readout column line under control of a select signal SEL.

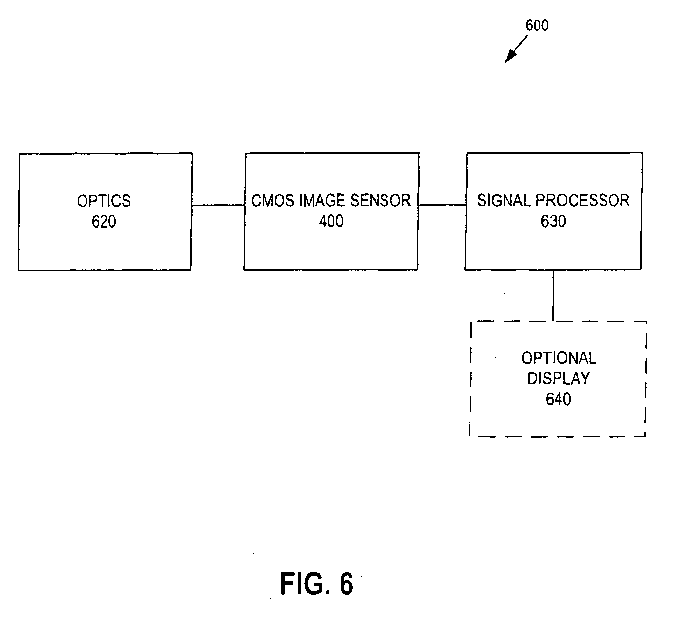

FIG. 6 illustrates an imaging system 600 that utilizes CIS 400, according to an embodiment of the disclosure. Image system 600 further includes imaging optics 620 for directing light from an item to be imaged onto CIS 400, and may also include a signal processor 630 for producing processed image data for display on a display 640.

The above description of illustrated embodiments of the invention, including what is described in the Abstract, is not intended to be exhaustive or to limit the embodiments to the precise forms disclosed. While specific embodiments are described herein for illustrative purposes, various modifications are possible within the scope, as those skilled in the relevant art will recognize. These modifications can be made in light of the above detailed description. Examples of some such modifications include dopant concentration, layer thicknesses, and the like. Further, although the embodiments illustrated herein refer to CMOS sensors using frontside illumination, it will be appreciated that they may also be applicable to CMOS sensors using backside illumination.

## Claims

1. An image sensor pixel (200), comprising:

   a photosensitive element (115) of a first conductivity type;
   a floating diffusion region (255) of a first conductivity type;
   a transfer transistor channel region disposed between the photosensitive element and the floating diffusion region, wherein a transfer transistor gate (205) is disposed over at least a portion of the transfer transistor channel region; and
   a doped well (240) of a second conductivity type, wherein the floating diffusion is disposed within the doped well and wherein the doped well extends below a portion of the transfer transistor gate;
   wherein the transfer transistor channel region includes a first channel sub-region (170) of the second conductivity type having a first doping concentration and a second channel sub-region (175) having a second doping concentration different from the first doping concentration;
   wherein the first channel sub-region extends over at least a portion of the photosensitive element and beneath a portion of the transfer transistor gate; and
   wherein the second channel sub-region is between the first channel sub-region and the doped well.

2. The image sensor pixel of claim 1, further comprising:

   a substrate (102); and
   an epitaxial layer (104) of the second conductivity type disposed over the substrate, wherein the photosensitive element, the floating diffusion region and the transfer transistor channel region are disposed in the epitaxial layer.

3. The image sensor pixel of claim 2, wherein the epitaxial layer has the second doping concentration.

4. The image sensor pixel of claim 2, wherein the epitaxial layer has a third doping concentration different from the first and second doping concentrations.

5. The image sensor pixel of claim 1, wherein the first channel sub-region has a width that is less than one-half a width of the transfer transistor gate.

**6.** The image sensor pixel of claim 1, wherein the doped well has a width that is less than one-half a width of the transfer transistor gate.

**7.** The image sensor pixel of claim 1, wherein the second channel sub-region is an undoped gap region.

**8.** The image sensor pixel of claim 1, further comprising a pinning layer (135) disposed over the photosensitive element.

**9.** An image sensor (400) comprising:

a complementary metal-oxide-semiconductor ("CMOS") array (405) of image sensor pixels disposed on a substrate, wherein each of the image sensor pixels is according to any of claims 1-8; and
readout circuitry (410) coupled to the CMOS array to readout image data from each of the image sensor pixels.


## Patentansprüche

**1.** Bildensorpixel (200), umfassend:

ein lichtempfindliches Element (115) eines ersten Leitfähigkeitstyps;
eine Floating-Diffusion-Region (255) eines ersten Leitfähigkeitstyps;
eine Transporttransistorkanalregion, die zwischen dem lichtempfindlichen Element und der Floating-Diffusion-Region angeordnet ist, worin ein Transporttransistorgate (205) über zumindest einem Abschnitt der Transporttransistorkanalregion angeordnet ist; und
ein dotierter Graben (240) eines zweiten Leitfähigkeitstyps, worin die Floating-Diffusion in dem dotierten Graben angeordnet ist und worin der dotierte Graben sich unterhalb eines Abschnitts des Transporttransistorgates erstreckt;
worin die Transporttransistorkanalregion eine erste Kanalunterregion (170) des zweiten Leitfähigkeitstyps mit einer ersten Dotierungskonzentration und eine zweite Kanalunterregion (175) mit einer zweiten Dotierungskonzentration, die sich von der ersten Dotierungskonzentration unterscheidet, umfasst;
worin die erste Kanalunterregion sich über zumindest einen Abschnitt des lichtempfindlichen Elements und unterhalb eines Abschnitts des Transporttransistorgates erstreckt; und
worin die zweite Kanalunterregion zwischen der ersten Kanalunterregion und dem dotierten Graben angeordnet ist.

**2.** Bildsensorpixel nach Anspruch 1, ferner umfassend:

ein Substrat (102); und
eine Epitaxialschicht (104) des zweiten Leitfähigkeitstyps, die auf das Substrat aufgebracht ist, worin das lichtempfindliche Element, die Floating-Diffusion-Region und die Transporttransistorkanalregionen in der Epitaxialschicht angeordnet sind.

**3.** Bildsensorpixel nach Anspruch 2, worin die Epitaxialschicht die zweite Dotierungskonzentration aufweist.

**4.** Bildsensorpixel nach Anspruch 2, worin die Epitaxialschicht eine dritte Dotierungskonzentration aufweist, die sich von der ersten und der zweiten Dotierungskonzentration unterscheidet.

**5.** Bildsensorpixel nach Anspruch 1, worin die erste Kanalunterregion eine Breite aufweist, die kleiner als eine halbe Breite des Transporttransistorgates ist.

**6.** Bildsensorpixel nach Anspruch 1, worin die dotierte Vertiefung eine Breite aufweist, die kleiner als eine halbe Breite des Transporttransistorgates ist.

**7.** Bildsensorpixel nach Anspruch 1, worin die zweite Kanalunterregion ein undotierter Spaltbereich ist.

**8.** Bildsensorpixel nach Anspruch 1, ferner umfassend eine Pinningschicht (135), die auf das lichtempfindliche Element aufgebracht ist.

**9.** Bildsensor (400), umfassend:

eine komplementäre Metalloxid-Halbleiter-("CMOS"-)Matrix (405) von Bildsensorpixeln, die auf einem Substrat angeordnet sind, wobei jeder der Bildsensorpixel den Ansprüchen 1 bis 8 entspricht; und
einen Ausleseschaltkreis (410), der mit der CMOS-Matrix verbunden ist, um Bilddaten aus jedem der Bildsensorpixel auszulesen.


## Revendications

**1.** Pixel de capteur d'image (200), comprenant :

un élément photosensible (115) d'un premier type de conductivité ;
une région de diffusion flottante (255) d'un premier type de conductivité ;
une région de canal de transistor de transfert disposée entre l'élément photosensible et la région de diffusion flottante, une grille de transistor de transfert (205) étant disposée sur au moins une partie de la région de canal de transistor de transfert ; et

un puits dopé (240) d'un second type de conductivité, la diffusion flottante étant disposée à l'intérieur du puits dopé et le puits dopé s'étendant en dessous d'une partie de la grille de transistor de transfert ;

dans lequel la région de canal de transistor de transfert comporte une première sous-région de canal (170) du second type de conductivité ayant une première concentration de dopage et une seconde sous-région de canal (175) ayant une deuxième concentration de dopage différente de la première concentration de dopage ;

dans lequel la première sous-région de canal s'étend sur au moins une partie de l'élément photosensible et au-dessous d'une partie de la grille de transistor de transfert ; et

dans lequel la seconde sous-région de canal se trouve entre la première sous-région de canal et le puits dopé.

2. Pixel de capteur d'image selon la revendication 1, comprenant en outre :

un substrat (102) ; et

une couche épitaxiale (104) du second type de conductivité disposée sur le substrat, l'élément photosensible, la région de diffusion flottante et la région de canal de transistor de transfert étant disposés dans la couche épitaxiale.

3. Pixel de capteur d'image selon la revendication 2, dans lequel la couche épitaxiale a la deuxième concentration de dopage.

4. Pixel de capteur d'image selon la revendication 2, dans lequel la couche épitaxiale a une troisième concentration de dopage différente des première et deuxième concentrations de dopage.

5. Pixel de capteur d'image selon la revendication 1, dans lequel la première sous-région de canal a une largeur qui est inférieure à la moitié d'une largeur de la grille de transistor de transfert.

6. Pixel de capteur d'image selon la revendication 1, dans lequel le puits dopé a une largeur qui est inférieure à la moitié d'une largeur de la grille de transistor de transfert.

7. Pixel de capteur d'image selon la revendication 1, dans lequel la seconde sous-région de canal est une région d'espace inter-électrodes non dopée.

8. Pixel de capteur d'image selon la revendication 1, comprenant en outre une couche d'ancrage (135) disposée sur l'élément photosensible.

9. Capteur d'image (400) comprenant :

une matrice de semi-conducteurs complémentaires à l'oxyde de métal (« CMOS ») (405) de pixels de capteur d'image disposée sur un substrat, dans lequel chacun des pixels de capteur d'image est conforme à l'une quelconque des revendications 1 à 8 ; et

des circuits de lecture (410) couplés à la matrice CMOS pour lire les données d'image provenant de chacun des pixels de capteur d'image.

**FIG. 1
(PRIOR ART)**

200

106

106

MICROLENS 125

COLOR
FILTER 120

METAL
STACK
110

M2

M2

M1

M1 M1

DIELECTRIC LAYER

P TYPE PINNING
LAYER 135

Ltx

POLY GATE 205

107

FD 255

170    175

STI
130

STI
130

PHOTOSENSITIVE
ELEMENT 115

PWELL
240

104

Locg    Lgap  Lpw

SUBSTRATE 102

**FIG. 2**

**FIG. 3A**

**FIG. 3B**

FD 255

POLY GATE 205

STI
130

170    175

PHOTOSENSITIVE
ELEMENT 115

104

PWELL
240

STI
130

SUBSTRATE 102

**FIG. 3C**

P TYPE PINNING
LAYER 135

FD 255

POLY GATE 205

STI
130

170    175

PHOTOSENSITIVE
ELEMENT 115

104

PWELL
240

STI
130

SUBSTRATE 102

**FIG. 3D**

400

405

| | C1 | C2 | C3 | C4 | C5 | | | ● ● ● | | | | | Cx |
|---|---|---|---|---|---|---|---|---|---|---|---|---|---|
| R1 | P1 | P2 | P3 | | | | | | | | | | |
| R2 | | | | | | | | | | | | | |
| R3 | | | | | | | | | | | | | |
| R4 | | | | | | | | | | | | | |
| R5 | | | | | | | | | | | | | |
| ● | | | | | | | | | | | | | |
| ● | | | | | | | | | | | | | |
| ● | | | | | | | | | | | | | |
| | | | | | | | | | | | | | |
| Ry | | | | | | | | | | | | Pn |

CONTROL
CIRCUITRY
420

READOUT CIRCUITRY 410

FUNCTION
LOGIC 415

READOUT COLUMNS

FIG. 4

13

READOUT COLUMN

PIXEL Pa

VDD

RST ── T2

TX ── T1

FD

SF

VDD

T3 SEL

T4

500

PD

PIXEL Pb

VDD

RST ── T2

TX ── T1

FD

SF

VDD

T3 SEL

T4

500

PD

## FIG. 5

600

| OPTICS | CMOS IMAGE SENSOR | SIGNAL PROCESSOR |
|:---:|:---:|:---:|
| 620 | 400 | 630 |

OPTIONAL
DISPLAY
640

FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060071254 A1